# EUROPEAN PATENT APPLICATION

(11) **EP 4 682 944 A1**
(43) Date of publication of application: **21.01.2026**
(21) Application number: 24731803.3
(22) Date of filing: 21.02.2024
(51) Int. Cl.: H01L 21/67, H01L 21/687, H01J 37/32, G01B 11/14

(54) **SUBSTRATE PROCESSING APPARATUS AND METHOD FOR CONTROLLING SUBSTRATE PROCESSING APPARATUS**

(30) Priority: 14.03.2023 KR 20230033266
(71) Applicant: PSK Inc., Hwaseong-si, Gyeonggi-do 18449 (KR)
(72) Inventor: KIM, Da In, Hwaseong-si, Gyeonggi-do 18449 (KR); CHOI, Min Ho, Hwaseong-si, Gyeonggi-do 18449 (KR); KIM, Byeong Hoon, Hwaseong-si, Gyeonggi-do 18449 (KR); LEE, Jong Chan, Hwaseong-si, Gyeonggi-do 18449 (KR); OH, Yong Ik, Hwaseong-si, Gyeonggi-do 18449 (KR); KIM, Geon Jong, Hwaseong-si, Gyeonggi-do 18449 (KR)
(74) Representative: HGF
(86) International application number: PCT/KR2024/002244
(87) International publication number: WO 2024/191069

(57) **Abstract**

Provided is a control method of a substrate processing apparatus, the control method including: a chuck moving operation of placing the substrate on a lower electrode and moving the lower electrode to a pre-set height; a gap measuring operation of measuring a gap between a top surface of the substrate and a dielectric plate positioned above the lower electrode; a correction determining operation of comparing the gap measured in the gap measuring operation with a pre-memorized process recipe to determine whether a correcting operation to correct the gap is necessary; and a correcting operation of moving the lower electrode so that the gap is consistent with the process recipe when it is determined that the correcting operation is necessary.

## Description

### Technical Field

The invention relates to a substrate processing apparatus and a control method of the substrate processing apparatus, and more particularly to a substrate processing apparatus for treating a film on a substrate by using plasma, and a control method of the substrate processing apparatus.

### Background Art

Plasma refers to an ionized gas state formed of ions, radicals, electrons, and the like, and is generated by a very high temperature, strong electric fields, or RF electromagnetic fields. The semiconductor device manufacturing process includes an etch process, which removes a film on a substrate, such as a wafer, by using plasma.

The plasma devices that perform the etch process include bevel etch devices that etch films on the edge regions of the substrate. A bevel etch device includes a lower electrode on which a substrate is placed, and a dielectric plate positioned on top of the lower electrode. The gap between the lower electrode and the dielectric plate (more precisely, the gap between a top surface of the substrate placed on the lower electrode and a bottom surface of the dielectric plate) affects the etch rate for the edge region of the substrate. The user sets the gap between the lower electrode and the dielectric plate in the process recipe, taking into account the range to which the film is to be removed from the substrate, the thickness of the film formed on the substrate, and the like.

Typically, the height of the lower electrode or dielectric plate is adjusted to match the gap between the lower electrode and the dielectric plate to the process recipe before plasma is generated. The plasma is then generated to remove the film on the substrate.

However, the thickness of the substrate placed on the lower electrode may vary for a variety of reasons. For example, the thickness of the substrate may vary depending on the type of substrate that the user selects, or even if the substrate is of the same type, the thickness may vary due to temperature changes in the substrate during processing the substrate, or due to various external factors affecting the substrate during transferring the substrate. Similarly, the lower electrode on which the substrate is placed and the dielectric plate positioned above the substrate may also be deformed.

The deformation of the substrate or the mechanisms around the substrate affects the gap between the top surface of the substrate and the dielectric plate. Therefore, even if the height of the lower electrode or the dielectric plate is adjusted to a preset height, the actual gap between the top surface of the substrate and the dielectric plate may not match the process recipe. In this case, the processing uniformity between the processed substrates deteriorates.

### Technical Problem

An object of the present invention is to provide a substrate processing apparatus capable of efficiently processing a substrate and a control method of the substrate processing apparatus.

Another object of the present invention is to provide a substrate processing apparatus capable of maintaining a desired gap between a substrate and a dielectric plate, and a control method of the substrate processing apparatus.

The problem to be solved by the present invention is not limited to the above-mentioned problems, and the problems not mentioned will be clearly understood by those skilled in the art from the present specification and the accompanying drawings.

### [Technical Solution]

An exemplary embodiment of the present invention provides an apparatus for processing a substrate, the apparatus including: a chamber having a processing space; a lower electrode for supporting a substrate in the processing space; a dielectric plate positioned above the lower electrode; a high frequency power source for generating plasma in the processing space; a driver for adjusting a gap between the lower electrode and the dielectric plate by adjusting a height of any one of the lower electrode and the dielectric plate; a gap measurement unit for measuring a gap between a top surface of a substrate placed on the lower electrode and the dielectric plate; and a controller for generating, based on a measurement value measured by the gap measurement unit, a control signal transmitted to the driver for correcting the gap between the top surface of the substrate placed on the lower electrode and the dielectric plate, in which the controller generates the control signal for correcting the gap between the top surface of the substrate placed on the lower electrode and the dielectric plate at a second time period during which the high frequency power source generates plasma.

According to the exemplary embodiment, the controller may generate the control signal for correcting the gap between the top surface of the substrate placed on the lower electrode and the dielectric plate, even in a first time period during which the high frequency power source does not generate plasma.

According to the exemplary embodiment, the controller may control the driver such that a second velocity at which the driver moves any one of the lower electrode and the dielectric plate in the second time period is slower than a first velocity at which the driver moves any one of the lower electrode and the dielectric plate in the first time period.

According to the exemplary embodiment, the controller may control the driver such that a second unit movement distance when the driver moves any one of the lower electrode and the dielectric plate at the second time period is less than a first unit movement distance when the driver moves any one of the lower electrode and the dielectric plate at the first time period.

According to the exemplary embodiment, the controller may compare the gap between the dielectric plate and the top surface of the substrate placed on the lower electrode, measured by the gap measurement unit, with a pre-memorized process recipe to determine whether a correcting operation of correcting the gap is necessary.

According to the exemplary embodiment, when the correcting operation is completed, the controller may further determine whether a drive range of the driver belongs to a critical drive range.

According to the exemplary embodiment, when the drive range of the driver belongs to the critical drive range, the controller may generate a control signal for the correcting operation of the driver.

According to the exemplary embodiment, the gap measurement unit may monitor the gap between the top surface of the substrate placed on the lower electrode and the dielectric plate while the correcting operation is performed, and when the gap between the top surface of the substrate placed on the lower electrode and the dielectric plate is outside a preset upper limit gap or a preset lower limit gap, the controller may generate a control signal for generating an alarm so that a user recognizes the fact that the gap between the top surface of the substrate placed on the lower electrode and the dielectric plate is outside the preset upper limit gap or the preset lower limit gap.

According to the exemplary embodiment, when the drive range of the driver does not belong to the critical drive range, a controller may generate a control signal for generating an alarm so that a user recognizes the fact that the drive range of the driver does not belong to the critical drive range.

According to the exemplary embodiment, the chamber may be provided with a pair of view ports, and the gap measurement unit may include: an emitting unit installed in any one of the view ports, and emitting light of a set width; and a light receiving unit installed in the other of the view ports, and receiving the light emitted by the emitting unit, and a portion of the light emitted by the emitting unit may overlap any of configurations of an upper electrode unit including the dielectric plate.

Another exemplary embodiment of the present invention provides a control method of a substrate processing apparatus, the control method including: a chuck moving operation of placing the substrate on a lower electrode and moving the lower electrode to a pre-set height; a gap measuring operation of measuring a gap between a top surface of the substrate and a dielectric plate positioned above the lower electrode; a correction determining operation of comparing the gap measured in the gap measuring operation with a pre-memorized process recipe to determine whether a correcting operation to correct the gap is necessary; and a correcting operation of moving the lower electrode so that the gap is consistent with the process recipe when it is determined that the correcting operation is necessary, in which the correcting operation is performed during a second time period of processing the substrate by using plasma.

According to the exemplary embodiment, the correcting operation may be performed even during a first time period during which the plasma is not generated.

According to the exemplary embodiment, a second velocity at which the lower electrode is moved in the second time period may be slower than a first velocity at which the lower electrode is moved in the first time period.

According to the exemplary embodiment, the control method may further include a critical drive determining operation of determining whether a drive range of a driver that moves the lower electrode belongs to a critical drive range when the correcting operation is completed, the critical drive determining operation being performed between the correction determining operation and the correcting operation.

According to the exemplary embodiment, when the drive range of the driver belongs to the critical drive range in the critical drive determining operation, the correcting operation may be performed, and when the drive range of the driver does not belong to the critical drive range in the critical drive determining operation, an alarm generating operation may be performed to generate an alarm so that a user recognizes the fact that the drive range of the driver does not belong to the critical drive range.

Still another exemplary embodiment of the present invention provides an apparatus for processing a substrate by using plasma, the apparatus including: a chamber having a processing space; a lower electrode unit provided in a lower portion of the processing space; an upper electrode unit provided in an upper portion of the processing space; a gas supply unit for supplying gas to the processing space; a gap measurement unit for measuring a gap between a substrate placed on the lower electrode unit and the upper electrode unit; and a controller for generating a control signal for correcting the gap between the substrate placed on the lower electrode unit and the upper electrode unit, based on a measurement value measured by the gap measurement unit, in which the lower electrode unit includes: a lower electrode on which the substrate is placed; a driver for moving the lower electrode in upper and lower directions; and a lower edge electrode configured in a shape of a ring surrounding the lower electrode when viewed from above, and the upper electrode unit includes: a dielectric plate positioned to face the lower electrode; and an upper edge electrode configured in a ring shape surrounding the dielectric plate and facing the lower edge electrode, when viewed from above, and the controller generates the control signal for correcting the gap between a top surface of the substrate placed on the lower electrode and the dielectric plate at a second time period during which the plasma is generated in the processing space.

According to the exemplary embodiment, the controller may generate the control signal for correcting the gap between the top surface of the substrate placed on the lower electrode and the dielectric plate, even in a first time period during which the plasma is not generated.

According to the exemplary embodiment, the controller may control the driver such that a second velocity at which the driver moves the lower electrode in the second time period is slower than a first velocity at which the driver moves the lower electrode in the first time period.

According to the exemplary embodiment, the controller may compare the gap between the dielectric plate and the top surface of the substrate placed on the lower electrode, measured by the gap measurement unit, with a pre-memorized process recipe to determine whether a correcting operation of correcting the gap is necessary, and when the correcting operation is completed, the controller may determine whether a drive range of the driver belongs to a critical drive range.

According to the exemplary embodiment, the gap measurement unit may monitor the gap between the top surface of the substrate placed on the lower electrode and the dielectric plate while the correcting operation is performed, and when the gap between the top surface of the substrate placed on the lower electrode and the dielectric plate is outside a preset upper limit gap or a preset lower limit gap, the controller may generate a control signal for generating an alarm so that a user recognizes the fact that the gap between the top surface of the substrate placed on the lower electrode and the dielectric plate is outside the preset upper limit gap or the preset lower limit gap.

### [Advantageous Effects]

According to the exemplary embodiment of the present invention, it is possible to efficiently treat the substrate.

Further, according to the exemplary embodiment of the present invention, it is possible to maintain a desired gap between a substrate and a dielectric plate.

The effect of the present invention is not limited to the foregoing effects, and the not-mentioned effects will be clearly understood by those skilled in the art from the present specification and the accompanying drawings.

### [Description of Drawings]

FIG. 1 is a cross-sectional view illustrating a substrate processing apparatus according to an exemplary embodiment of the present invention.
FIGS. 2 and 3 are diagrams illustrating a method of measuring, by a gap measurement unit, a gap between a top surface of a substrate and a bottom surface of a dielectric plate.
FIG. 4 is a diagram illustrating the substrate processing apparatus of FIG. 1 processing a substrate.
FIG. 5 is a flowchart illustrating a control method of the substrate processing apparatus according to an exemplary embodiment of the present invention.
FIG. 6 is a table illustrating a movement velocity of a chuck that is a lower electrode, and a unit movement distance of a motor depending on whether plasma is generated, in an correcting operation.
FIG. 7 is a cross-sectional view illustrating a substrate processing apparatus according to another exemplary embodiment of the present invention.

Various features and advantages of the non-limiting exemplary embodiments of the present specification may become apparent upon review of the detailed description in conjunction with the accompanying drawings. The attached drawings are provided for illustrative purposes only and should not be construed to limit the scope of the claims. The accompanying drawings are not considered to be drawn to scale unless explicitly stated. Various dimensions in the drawing may be exaggerated for clarity.

### [Best Mode]

Exemplary embodiments will now be described more fully with reference to the accompanying drawings. The exemplary embodiments are provided in order to make the disclosure exhaustive and will fully convey the scope to one of ordinary skill in the art. To provide a complete understanding of exemplary embodiments of the present invention, a number of specific details are presented, such as examples of certain components, devices, and methods. It will be apparent to those skilled in the art that specific details need not be utilized and that the exemplary embodiments may be implemented in many different forms, neither of which should be construed as limiting the scope of the present invention. In some exemplary embodiments, known processes, known device structures, and known techniques are not described in detail.

The terminology used herein is intended to describe certain exemplary embodiments only and is not intended to limit the exemplary embodiments. Singular expressions, such as those used herein, or expressions where the singular is not specified, are intended to include the plural expressions unless the context clearly indicates otherwise. The terms "includes", "comprising", "including", and "having" have an open-ended meaning and are therefore intended to specify the presence of the features, configurations, integers, steps, operations, elements, and/or components mentioned and do not exclude the presence or addition of one or more other features, configurations, steps, operations, elements, components, and/or groups thereof. The method steps, processes, and operations described herein are not to be construed as necessarily being performed in the particular order in which they are discussed or described, unless the order in which they are performed is specified. In addition, additional or alternative steps may be selected.

When an element or layer is referred to as being "on", "connected to", "bonded to", "attached to", "adjacent to", or "covering" another element or layer, the element or layer may be directly on, connected to, bonded to, attached to, adjacent to, or covering the other element or layer, or intermediate elements or layers may be present. Conversely, when an element is referred to as being "directly on", "directly connected to", or "directly bonded to" another element or layer, it is to be understood that no intervening elements or layers are present. Throughout the specification, the same reference numeral refers to the same element. As used in the present invention, the term "and/or" includes all combinations and sub-combinations of one or more of the enumerated items.

Although terms, such as first, second, and third, may be used to describe various elements, regions, layers, and/or sections of the present invention, it is to be understood that these elements, regions, layers, and/or sections are not to be limited by these terms. These terms are used to distinguish one element, region, layer, or section from another element, region, layer, or section only. Accordingly, the first element, first region, first floor, or first section discussed below may be referred to as the second element, second region, second floor, or second section without departing from the teachings of the exemplary embodiments.

Spatially relative terms (for example, "beneath", "underneath", "below", "on", "above", and "on top") may be used for ease of description to describe the relationship of one element or feature to another element(s) or feature(s) as illustrated in the drawings. It is to be understood that spatially relative terms are intended to include not only the orientations illustrated in the drawings, but also other orientations of the apparatus in use or operation. For example, when the device in the drawing is flipped, the elements described as "underneath" or "below" other elements or features may be oriented "above" other elements or features. Thus, the term "below" above may include both up and down orientations. The apparatus may be oriented differently (rotated 90 degrees, or otherwise oriented), and the spatially relative descriptive phrases used in the present invention may be construed accordingly.

It should be understood that when the terms "same" or "equal" are used in the description of exemplary embodiments, some imprecision may exist. Accordingly, when an element or value is referred to as being equal to another element or value, it is to be understood that the corresponding element or value is equal to the other element or value within manufacturing or operating tolerances (e.g., ±10%).

Where the words "approximately" or "substantially" are used in the present specification with respect to a numerical value, the corresponding numerical value should be understood to include manufacturing or operating tolerances (e.g., ±10%) of the mentioned numerical value. It should also be understood that the use of the words "generally" and "substantially" in reference to geometric shapes does not require geometric shape accuracy, but latitude for shape is within the scope of the disclosure.

Unless otherwise defined, all terms used in the present invention, including technical and scientific terms, have the same meaning as commonly understood by one of ordinary skill in the art to which the exemplary embodiments belong. It is also to be understood that terms, including commonly used dictionary-defined terms, are to be interpreted to have a meaning consistent with their meaning in the context of the relevant art and are not to be construed in an idealized or overly formal sense unless expressly defined in the present invention.

A substrate to be processed as described herein is described, for example, as a wafer. Further, a substrate processing apparatus described herein is described, for example, as a bevel etch apparatus for removing a film formed on an edge region of a substrate. Furthermore, the substrate processing apparatus described herein is described, for example, as a dry etch apparatus that removes a film formed on an edge region of a substrate using plasma.

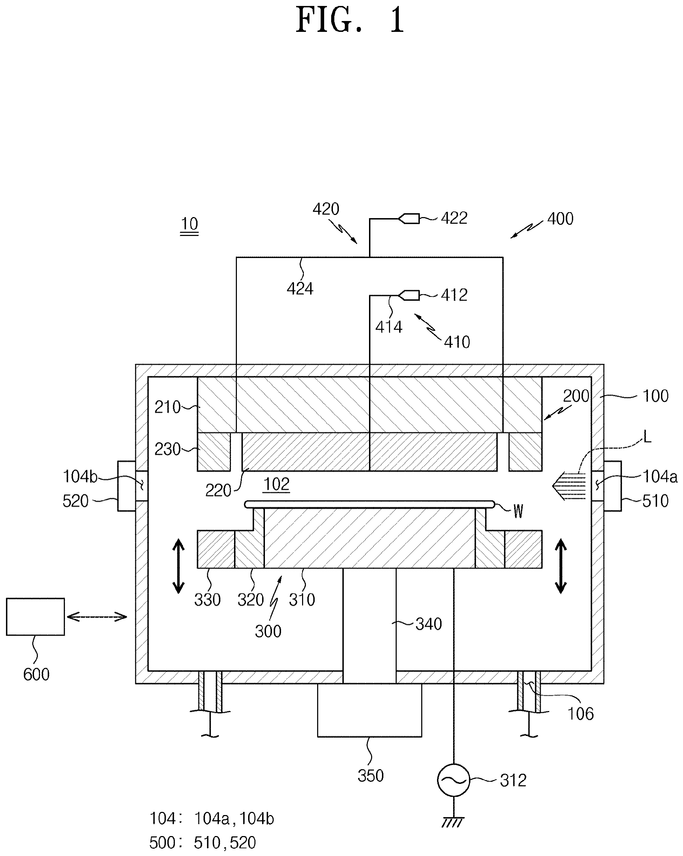

FIG. 1 is a cross-sectional view illustrating a substrate processing apparatus according to an exemplary embodiment of the present invention.

Referring to FIG. 1, a substrate processing apparatus 10 according to an exemplary embodiment of the present invention may include a chamber 100, an upper electrode unit 200, a lower electrode unit 300, a gas supply unit 400, a gap measurement unit 500, and a controller 600.

The chamber 100 may have a processing space 102. The chamber 100 may define the processing space 102 where the substrate W is processed. An inner wall of the chamber 100 may have a coating layer formed thereon that is highly corrosion resistant to plasma. The chamber 100 may have an overall hexahedral shape. The chamber 100 may have an inlet (not illustrated) into or from which the substrate W may be loaded or unloaded. The inlet may be selectively opened/closed by a door (not illustrated). The inlet may be closed by the door such that the processing space 102 may be sealed from the outside while processing is being performed on the substrate W.

The chamber 100 may be provided with view ports 104. The view ports 104 may be provided in pairs. For example, the view ports 104 may include a first view port 104a and a second view port 104b. The first view port 104a and the second view port 104b may face each other. The view port 104 may be equipped with the gap measurement unit 500, which is to be described later.

The exhaust hole 106 may exhaust the processing space 102. The exhaust hole 106 may be connected to an exhaust device that provides depressurization to exhaust the processing space 102. For example, the exhaust device may be a pump. While the substrate W is being processed, the pressure in the processing space 102 may be adjusted by the depressurization provided through the exhaust hole 106 and the gas supplied by the gas supply unit 400, which is to be described later. While the substrate W is being processed, the pressure in the processing space 102 may be controlled to a vacuum or very low pressure near vacuum. However, the present invention is not limited thereto, and the pressure in the processing space 102 while the substrate W is being processed may be varied depending on the selection of the user.

The upper electrode unit 200 may be located in an upper portion of the processing space 102. The upper electrode unit 200 may include a base 210, a dielectric plate 220, and an upper edge electrode 230. The base 210 may be installed in an upper portion of the chamber 100. The base 210 may be formed of a material that is easily machined, such as metal. The dielectric plate 220 and the upper edge electrode 230 may be fixedly installed in the chamber 100 via the base 210.

The dielectric plate 220 may be formed of a dielectric substance. The dielectric plate 220 may be formed of a material including a ceramic. The dielectric plate 220 may have a substantially disk-like shape when viewed from above. The dielectric plate 220 may face a lower electrode 310, which is to be described later. The dielectric plate 220 may be installed below the center region of the base 210.

The upper edge electrode 230 may be formed of a conductive material. The upper edge electrode 230 may be formed of a material including a metal. The upper edge electrode 230 may have an overall ring shape. The upper edge electrode 230 may be configured to surround the dielectric plate 220 when viewed from above. The upper edge electrode 230 may be provided to be spaced apart from the dielectric plate 220 and each other. The top edge electrode 230 may be grounded. Alternatively, the upper edge electrode 230 may be connected to a high frequency power source (not illustrated).

The lower electrode unit 300 may be located in a lower portion of the processing space 102. The lower electrode unit 300 may include a lower electrode 310, a high frequency power source 312, an insulating ring 320, a lower edge electrode 330, a drive shaft 340, and a driver 350. The inclusion of the lower electrode 310, the insulating ring 320, and the lower edge electrode 330 may be referred to as a chuck.

The lower electrode 310 may support the substrate W. The lower electrode 310 may have a seating surface on which the substrate W is placed. The lower electrode 310 may be connected to a high frequency power source 312. The high frequency power source 312 may apply high frequency power to the lower electrode 310. The lower electrode 310 may be formed of a conductive material. The lower electrode 310 may be provided with a material including a metal. The high frequency power source 312 may generate plasma in the processing space 102.

The insulating ring 320 may be provided to surround the lower electrode 310. The insulating ring 320 may be formed of a material having insulating properties. The insulating ring 320 may be provided between the lower edge electrode 330 and the lower electrode 310. When viewed from above, the insulating ring 320 may be configured in the shape of a ring surrounding the lower electrode 310. The top surface of the insulating ring 320 may have a stepped shape such that the inner top surface is higher than the outer top surface.

The lower edge electrode 330 may be provided to surround the insulating ring 320. The lower edge electrode 330 may be formed of a conductive material. The lower edge electrode 330 may be configured in a ring shape that surrounds the insulating ring 320 when viewed from above. The lower edge electrode 330 may be grounded. Alternatively, the lower edge electrode 330 may be connected to a high frequency power source (not illustrated).

The drive shaft 340 may be connected to a lower portion of the lower electrode 310. The drive shaft 340 may be moved in upper and lower directions by the driver 350. The drive shaft 340 may receive power from the driver 350 to move the lower electrode 310 in the upper and lower directions.

The driver 350 may transmit power to the drive shaft 340, which may adjust the height of the lower electrode 310. The driver 350 may move the lower electrode 310 in the upper and lower directions. By adjusting the height of the lower electrode 310, the driver 350 may adjust the gap between the lower electrode 310 and the dielectric plate 220. The driver 350 may include a motor, and an encoder, which may be a sensor that senses the number of revolutions, velocity of rotation, and direction of rotation of the motor. The number of revolutions of the motor sensed by the encoder of the driver 350 may be transmitted to the controller 600 which is to be described later. The controller 600 may calculate the height of the lower electrode 310 from the number of revolutions of the motor from a reference value. In other words, the controller 600 may determine a current height of the lower electrode 310 from the number of revolutions of the motor sensed by the encoder of the driver 360.

The gas supply unit 400 may supply gas to the processing space 102. The gas supply unit 400 may include a first gas supply unit 410 that supplies inert gas (an example of first gas) to a center region of the substrate W, and a second gas supply unit 420 that supplies process gas (an example of second gas) to an edge region of the substrate W. The inert gas may be gas, such as nitrogen or argon. The process gas may be gas that is excited to a plasma state, and may be selected by the user depending on the type of film to be removed.

The first gas supply unit 410 may include a first gas supply source 412 storing and/or supplying the first gas, and a first gas supply line 414 transmitting the first gas from the first gas supply source 412. The second gas supply unit 420 may include a second gas supply source 422 storing and/or supplying the second gas, and a second gas supply line 424 transmitting the second gas from the second gas supply source 422. The first gas may be supplied to the substrate W through a flow path (not illustrated) formed in the dielectric plate 220, and the second gas may be supplied to the substrate W through the space between the dielectric plate 220 and the upper edge electrode 230.

The gap measurement unit 500 may measure the gap between the bottom surface of the dielectric plate 220 and the top surface of the substrate W placed on the lower electrode 310. The gap measurement unit 500 may include an emitting unit 510 installed at the first view port 104a and a light receiving unit 520 installed at the second view port 104b. Light L emitted by the emitting unit 510 through the first view port 104a may be received by the light receiving unit 520 through the second view port 104b. The vertical width of the light L being received by the light receiving unit 520 may be transmitted to the controller 600, and the controller 600 may monitor the gap between the bottom surface of the dielectric plate 220 and the substrate W placed on the bottom electrode 310.

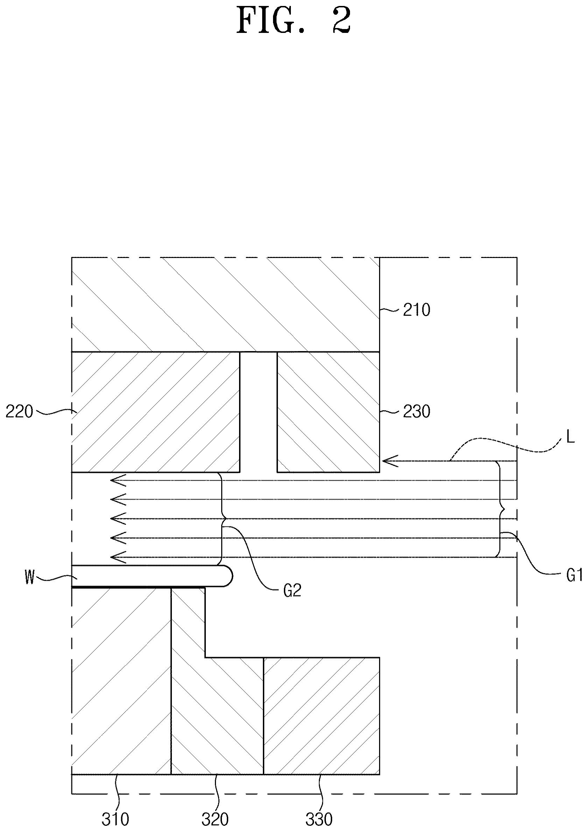

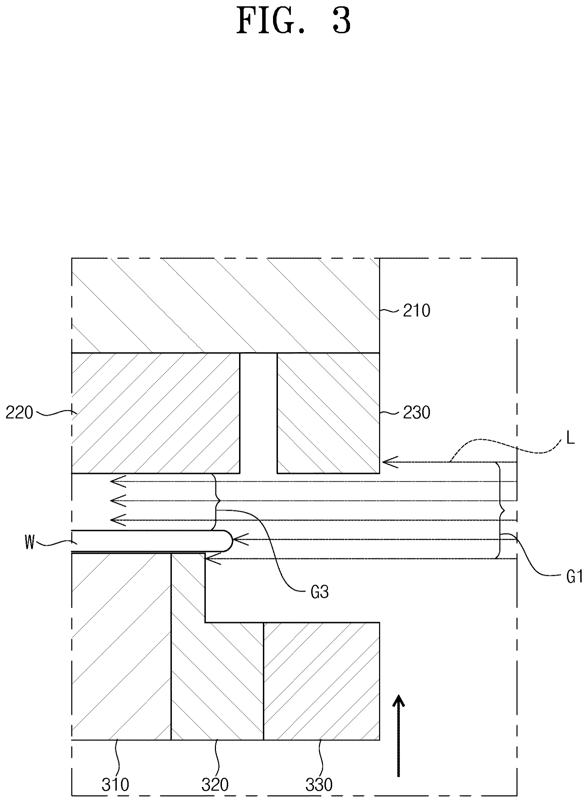

FIGS. 2 and 3 are diagrams illustrating a method of measuring, by the gap measurement unit, a gap between the top surface of the substrate and the bottom surface of the dielectric plate.

FIG. 2 illustrates a case where the light L does not overlap with the lower electrode unit 300 and the substrate W, and FIG. 3 illustrates a case where a portion of the light L overlaps the lower electrode unit 300 and the substrate W.

Referring to FIGS. 1 and 2, the vertical width of the light L emitted by the emitting unit 510 through the first view port 104a may be a first width G1. At least a portion of the light L may overlap a configuration of the upper electrode unit 200, such as the upper edge electrode 230. Accordingly, the vertical width of the light L received through the light receiving unit 520 may be a second width G2.

Referring to FIGS. 1 and 3, when the height of the lower electrode 310 is increased, the vertical width of the light L received through the light receiving unit 520 may be a third width G3. The third width G3 may be a smaller width than the second width G2. The controller 600 may calculate a value obtained by subtracting the third width G3 from the second width G2 as a gap between the top surface of the substrate W and the bottom surface of the dielectric plate 220.

For example, when the first width G1 is 10 mm and the second width G2 is 9 mm, and the lower electrode 310 is raised so that the third width G3 is 5 mm, the difference value of 4 mm between the second width G2 and the third width G3 may be calculated as the gap between the top surface of the substrate W and the bottom surface of the dielectric plate 220.

Referring again to FIG. 1, the controller 600 may control the configurations of the substrate processing apparatus 10. The controller 600 may generate a control signal to control the driver 350 based on the measurement value measured by the gap measurement unit 500. The control signal may be a signal for performing a correcting operation to correct the gap between the top surface of the substrate W placed on the lower electrode 310 and the bottom surface of the dielectric plate 220.

The controller 600 may include a process controller formed of a microprocessor (computer) that executes the control of the substrate processing apparatus 10, a user interface formed of a keyboard in which an operator performs a command input operation or the like in order to manage the substrate processing apparatus 10, a display for visualizing and displaying an operation situation of the substrate processing apparatus 10, and the like, and a storage unit storing a control program for executing the process executed in the substrate processing apparatus 10 under the control of the process controller or a program, that is, a treating recipe, for executing the process in each component according to various data and treating conditions. Further, the user interface and the storage unit may be connected to the process controller. The treating recipe may be memorized in a storage medium in the storage unit, and the storage medium may be a hard disk, and may also be a portable disk, such as a CD-ROM or a DVD, or a semiconductor memory, such as a flash memory.

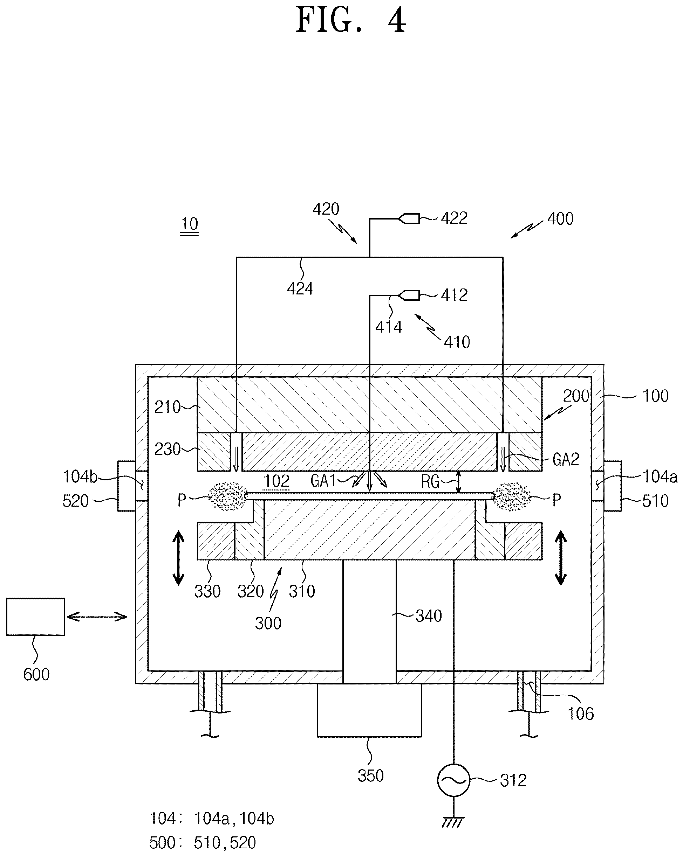

FIG. 4 is a diagram illustrating the substrate processing apparatus of FIG. 1 processing a substrate.

Referring to FIG. 4, the controller 600 may have a process recipe memorized in advance. The process recipe may include a value for the gap between the top surface of the substrate W and the dielectric plate 220. When performing a processing operation on the substrate W, the controller 600 may transmit a control signal to the driver 350 to adjust the gap between the substrate W and the dielectric plate 220 to a set gap RG. Then, the gas supply unit 400 may supply first gas GA1 to the center region of the substrate W, supply second gas GA2 to the edge region, and generate the plasma P from the second gas GA2.

The present invention may adjust the gap between the substrate W and the dielectric plate 220 to be the set gap RG in a first time period during which the plasma P is not generated, and may maintain the gap between the substrate W and the dielectric plate 220 at the set gap RG in a second time period during which the plasma P is generated.

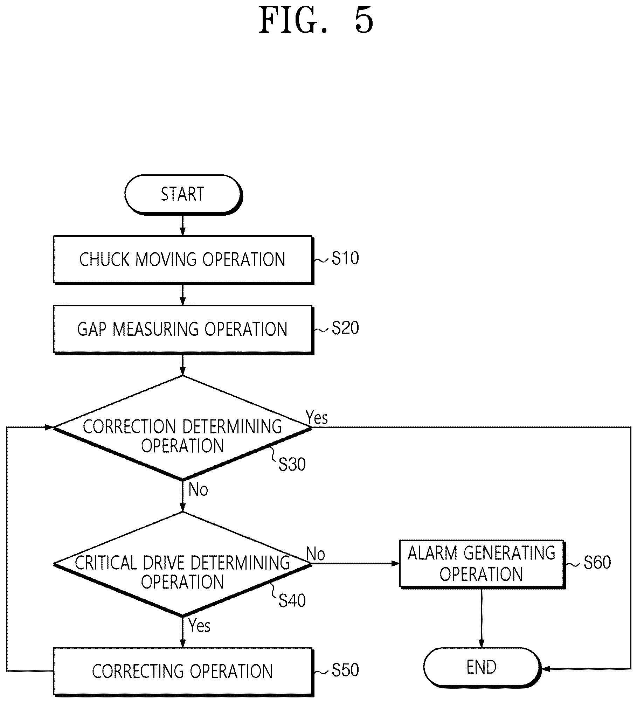

FIG. 5 is a flowchart illustrating a control method of the substrate processing apparatus according to an exemplary embodiment of the present invention. Hereinafter, with reference to FIGS. 1, 4, and 5, a height correcting operation of the lower electrode 310 at the first time period will be described in detail.

### [Height correcting operation of the lower electrode 310 in the first time period]

The correcting operation in the first time period during which the plasma P is not generated (before processing the substrate W, or after processing the substrate W) may include a chuck moving operation S10, a gap measuring operation S20, a correction determining operation S30, a critical driving determining operation S40, a correcting operation S50, and an alarm generating operation S60.

The chuck moving operation S10 includes adjusting the height of the lower electrode 310. The chuck moving operation S10 includes placing the substrate W on the lower electrode 310 and moving the lower electrode 310 to a preset height. The height of the lower electrode 310 may be preset to a value corresponding to a gap between the top surface of the substrate W placed on the lower electrode 310 and the bottom surface of the dielectric plate 220, the value being memorized as a process recipe in the controller 600. In the chuck moving operation S10, the height of the lower electrode 310 is adjusted based on the process recipe pre-memorized in the controller 600, independent of the measurement value of the gap measurement unit 500. The controller 600 generates a control signal to control the driver 350. The driver 350 may move the lower electrode 310 to a height corresponding to the foregoing gap.

The gap measuring operation S20 includes measuring a gap between the top surface of the substrate W and the bottom surface of the dielectric plate 220. In the gap measuring operation S20, the controller 600 may calculate a gap between the top surface of the substrate W and the dielectric plate 220 based on the measurement value measured by the gap measurement unit 500.

The correction determining operation S30 includes determining whether the gap calculated by the gap measurement operation S20 is consistent with the process recipe. The correction determining operation S30 may include comparing the gap measured in the gap measuring operation S20 with the process recipe pre-memorized in the controller 600 to determine whether a correcting operation to correct the above gap is necessary. Whether the gap is consistent with the process recipe may be determined by whether the calculated gap is the same as the set gap RG set as the process recipe, or if there is a slight difference, whether the difference is within a predetermined range. When the calculated gap is in consistent with the process recipe, the movement of the lower electrode 310 is terminated. When the calculated gap is not in consistent with the process recipe, a distance that the lower electrode 310 needs to move in order for the calculated gap to be in constituent with the process recipe is calculated. For example, when the calculated gap is greater than the set gap RG, the difference between the calculated gap and the set gap RG may be calculated as the distance by which the lower electrode 310 needs to be moved in the upper direction. Then, the critical driving determining operation S40 is performed.

The critical driving determining operation S40 may include, when the controller 600 moves the lower electrode 310 by the distance calculated in the correction determining operation S30 (that is, when the correcting operation is completed), determining whether the driving range of the driver 350 that moves the lower electrode 310 belongs to a critical driving range.

When the height of the lower electrode 310 is excessively high, or when the height of the lower electrode 310 is excessively low, the lower electrode 310 may conflict with various configurations of the substrate processing apparatus 10. For example, when the height of the lower electrode 310 is excessively high, the lower electrode 310 may collide with the dielectric plate 220. For example, even though the height of the lower electrode 310 is such that it does not touch the dielectric plate 220, when the gap between the lower electrode 310 and the dielectric plate 220 is excessively narrow, the risk of collision between the lower electrode 310 and the dielectric plate 220 increases. Accordingly, the user presets a critical driving range of the driver 350. The user may preset the critical driving range of the driver 350 via the controller 600, or the user may preset the critical driving range of the driver 350 via the autonomous operation of the driver 350.

In other words, the critical driving determining operation S40 includes determining whether the driving range of the driver 350 belongs between a critical upper limit value and a critical lower limit value (the critical driving range) when it is determined that the correcting operation is necessary in the correction determining operation S30 and when the correcting operation is completed. When the driving range of the driver 350 belongs to the critical drive range, the correcting operation S50 described below is performed to implement the correcting operation, and when the driving range of the driver 350 does not belong to the critical drive range, the alarm generating operation S60 described below is performed.

In the correcting operation S50, the controller 600 may generate a control signal to drive the driver 350. The driver 350 may be driven to adjust the height of the lower electrode 310. The controller 600 generates a control signal to control the driver 350 to move the lower electrode 310 so that the gap between the top surface of the substrate W placed on the lower electrode 310 and the bottom surface of the dielectric plate 220 is the set gap RG. Further, in the correcting operation S50, the gap measurement unit 500 continuously monitors the gap between the top surface of the substrate W and the bottom surface of the dielectric plate 220. When the monitored gap does not belong to a preset upper limit critical gap and a preset lower limit critical gap (critical gap range), the controller 600 may stop the driver 350 and perform the alarm generating operation S60.

In the alarm generating operation S60, when the driving range of the driver 350 simulated in the critical driving determining operation S40 does not belong to the critical driving range, or when the gap monitored by the gap measurement unit 500 in the correcting operation S50 does not belong to the critical gap range, the controller 600 may generate a control signal to stop the operation of the driver 350, as well as a control signal to generate an alarm so that the user is capable of recognizing the fact that the gap does not belong to the critical gap range. The alarm may be generated in any manner, such as by the generation of a sound through a speaker and/or a visual indication through a display device, such as a display that the controller 600 may have.

Hereinafter, with reference to FIGS. 1, 4, and 5, the height correcting operation of the lower electrode 310 at the second time period will be described in detail.

### [Height correcting operation of the lower electrode 310 at the second time period]

In the correcting operation in the second time period during which the substrate W is processed by generating plasma P, the gap measuring operation S20, the correction determining operation S30, the critical driving determining operation S40, the correcting operation S50, and the alarm generating operation S60 may be performed the same or similarly to the correcting operation in the first time period. Hereinafter, the differences from the height correcting operation of the lower electrode 310 in the first time period will be described in detail.

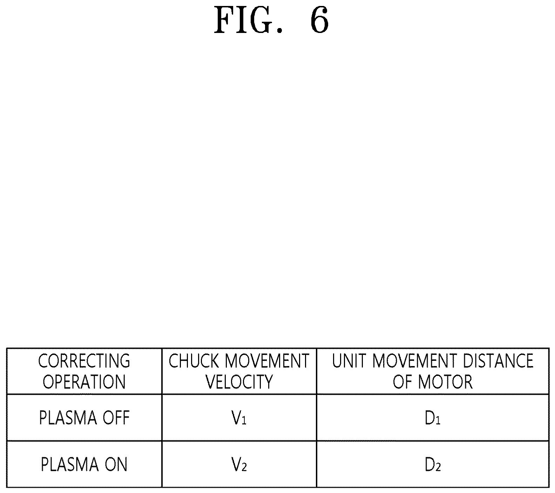

FIG. 6 is a table illustrating a movement velocity of a chuck that is a lower electrode, and a unit movement distance of a motor depending on whether plasma is generated, in the correcting operation.

Referring to FIGS. 1, 4, and 6, during the correcting operation in the first time period during which plasma P is generated (plasma off), the chuck including the lower electrode 310 may have a first velocity V1. In the correcting operation at the second time period (plasma on) in which plasma P is generated, the movement velocity of the chuck including the lower electrode 310 may have a second velocity V2. The second velocity V2 may be a slower velocity than the first velocity V1. The first time aims to adjust the gap between the top surface of the substrate W and the bottom surface of the dielectric plate 220 to the set gap RG, and the second time period aims to maintain the gap adjusted in the first time period at the set gap RG, and in particular, processing is being performed on the substrate W in the second time period, so that it is advantageous to reduce the movement velocity of the chuck to perform the process stably.

Further, the unit movement distance of the motor of the driver 350 may be adjusted by the controller 600. For example, in the first time period, the unit movement distance of the motor may be set to a first unit movement distance D1, and in the second time period, the unit movement distance of the motor may be set to a second unit movement distance D2. The second unit movement distance D2 may be smaller than the first unit movement distance D1. For example, the second unit movement distance D2 may be 1 micrometer. The first unit movement distance D1 may be 10 micrometers. By making the unit movement distance of the motor relatively large at the first time period, the gap may be adjusted quickly.

In the examples described above, the present invention has been described based on the case where the height of the dielectric plate 220 is fixed and the height of the lower electrode 310 is adjusted has been described as an example, but the present invention is not limited thereto. For example, the gap between the dielectric plate 220 and the bottom electrode 310 may also be adjusted by providing a separate driving mechanism that adjusts the height of the dielectric plate 220, and adjusting the height of the dielectric plate 220 by the driver including the driving mechanism.

In the exemplary embodiments described above, the present invention has been described based on the case where the substrate processing apparatus 10 is a bevel etch apparatus as an example, but the present invention is not limited thereto. For example, the substrate processing apparatus may be a Capacitively Coupled plasma (CCP) type plasma device, or an Inductively Coupled Plasma (ICP) type plasma device.

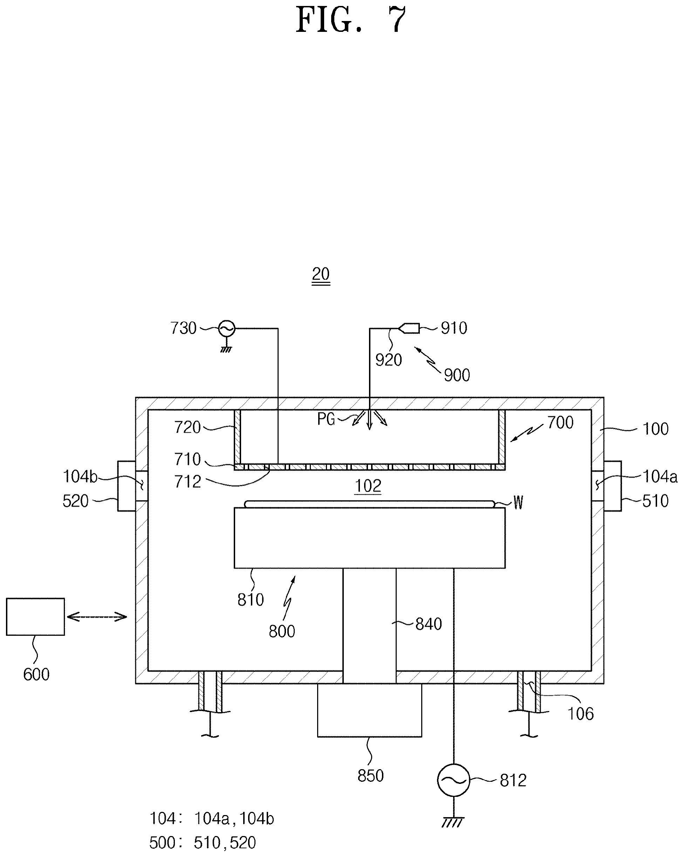

For example, as illustrated in FIG. 7, a substrate processing apparatus 20 may be provided as a CCP type plasma device. The substrate processing apparatus 20 may include a chamber 100, a gap measurement unit 500, and a controller 600, identically or similarly to the substrate processing apparatus 10.

The substrate processing apparatus 20 may include an upper electrode unit 700, a lower electrode unit 800, and a gas supply unit 900.

The upper electrode unit 700 may be provided in an upper portion of the processing space 102. The lower electrode unit 800 may be provided in the lower portion of the processing space 102. The upper electrode unit 700 may include a shower head 710 having a plurality of holes 712 formed therein, and a fixing frame 720 for fixing the shower head 710 to the chamber 100. The fixing frame 720 may be provided with a dielectric. The shower head 710 may be connected to the upper power source 730. The upper power source 730 may be a high frequency power source. The fixing frame 720 may have a generally ring shape. The shower head 710 may be provided from a material including metal. The upper power source 730 may be a source RF that generates plasma from process gas PG in the processing space 102. The shower head 710 may be an upper electrode. The shower head 710 may be positioned to face the lower electrode 810 such that the shower head 710 is opposite the lower electrode 810.

The lower electrode unit 800 may include a lower electrode 810, a drive shaft 840, and a driver 850. The lower electrode 810, the drive shaft 840, and the driver 850 may have the same or similar structure as the lower electrode 310, the drive shaft 340, and the driver 350 described above. Further, the lower electrode 810, the drive shaft 840, and the driver 850 may be controlled in the same or similar manner as the lower electrode 310, the drive shaft 340, and the driver 350 described above.

The gas supply unit 900 may supply process gas PG to the top side of the shower head 710. The process gas PG may enter the processing space 102 through the holes 712, and the process gas PG entering the processing space 102 may be excited and converted to a plasma state.

In the case of the CCP-type substrate processing apparatus 20, it may also be necessary to adjust the gap between the top surface of the substrate W placed on the lower electrode 810 and the upper electrode unit 700. For example, when the substrate W is processed by using the substrate processing unit 20, it may be necessary to adjust the gap between the top surface of the substrate W placed on the lower electrode 810 and the shower head 710 to adjust the processing efficiency for the substrate W, and the like. This is because a narrowing of the gap results in a smaller volume of the space in which the plasma is primarily generated in the processing space 102, and a widening of the gap results in a larger volume of the space in which the plasma is primarily generated in the processing space 102.

Therefore, similar to the substrate processing apparatus 10 described above, the substrate processing apparatus 20 may also correct the gap between the top surface of the substrate W placed on the lower electrode 810 and the lower surface of the shower head 710 by the gap measurement unit 500 and the controller 600.

In some cases, the substrate processing apparatus to which the correcting operation by the gap measurement unit 500 and the controller 600 is applied may be an ICP type plasma device. In this case, the upper electrode unit may include an antenna formed of a coil or the like, and a dielectric plate positioned downstream of the antenna.

It should be understood that exemplary embodiments are disclosed herein and that other variations may be possible. Individual elements or features of a particular exemplary embodiment are not generally limited to the particular exemplary embodiment, but are interchangeable and may be used in selected exemplary embodiments, where applicable, even if not specifically illustrated or described. The modifications are not to be considered as departing from the spirit and scope of the present invention, and all such modifications that would be obvious to one of ordinary skill in the art are intended to be included within the scope of the accompanying claims.

## Claims

1. An apparatus for processing a substrate, the apparatus comprising:
a chamber having a processing space;
a lower electrode for supporting a substrate in the processing space;
a dielectric plate positioned above the lower electrode;
a high frequency power source for generating plasma in the processing space;
a driver for adjusting a gap between the lower electrode and the dielectric plate by adjusting a height of any one of the lower electrode and the dielectric plate;
a gap measurement unit for measuring a gap between a top surface of a substrate placed on the lower electrode and the dielectric plate; and
a controller for generating, based on a measurement value measured by the gap measurement unit, a control signal transmitted to the driver for correcting the gap between the top surface of the substrate placed on the lower electrode and the dielectric plate,
wherein the controller generates the control signal for correcting the gap between the top surface of the substrate placed on the lower electrode and the dielectric plate at a second time period during which the high frequency power source generates plasma.

2. The apparatus of claim 1, wherein the controller generates the control signal for correcting the gap between the top surface of the substrate placed on the lower electrode and the dielectric plate, even in a first time period during which the high frequency power source does not generate plasma.

3. The apparatus of claim 2, wherein the controller controls the driver such that a second velocity at which the driver moves any one of the lower electrode and the dielectric plate in the second time period is slower than a first velocity at which the driver moves any one of the lower electrode and the dielectric plate in the first time period.

4. The apparatus of claim 2, wherein the controller controls the driver such that a second unit movement distance when the driver moves any one of the lower electrode and the dielectric plate at the second time period is less than a first unit movement distance when the driver moves any one of the lower electrode and the dielectric plate at the first time period.

5. The apparatus of any one of claims 1 to 4, wherein the controller compares the gap between the dielectric plate and the top surface of the substrate placed on the lower electrode, measured by the gap measurement unit, with a pre-memorized process recipe to determine whether a correcting operation of correcting the gap is necessary.

6. The apparatus of claim 5, wherein when the correcting operation is completed, the controller further determines whether a drive range of the driver belongs to a critical drive range.

7. The apparatus of claim 6, wherein when the drive range of the driver belongs to the critical drive range, the controller generates a control signal for the correcting operation of the driver.

8. The apparatus of claim 7, wherein the gap measurement unit monitors the gap between the top surface of the substrate placed on the lower electrode and the dielectric plate while the correcting operation is performed, and
when the gap between the top surface of the substrate placed on the lower electrode and the dielectric plate is outside a preset upper limit gap or a preset lower limit gap, the controller generates a control signal for generating an alarm so that a user recognizes the fact that the gap between the top surface of the substrate placed on the lower electrode and the dielectric plate is outside the preset upper limit gap or the preset lower limit gap.

9. The apparatus of claim 6, wherein when the drive range of the driver does not belong to the critical drive range, a controller generates a control signal for generating an alarm so that a user recognizes the fact that the drive range of the driver does not belong to the critical drive range.

10. The apparatus of any one of claims 1 to 4, wherein the chamber is provided with a pair of view ports, and
the gap measurement unit includes:
an emitting unit installed in any one of the view ports, and emitting light of a set width; and
a light receiving unit installed in the other of the view ports, and receiving the light emitted by the emitting unit, and
a portion of the light emitted by the emitting unit overlaps any of configurations of an upper electrode unit including the dielectric plate.

11. A control method of a substrate processing apparatus, the control method comprising:
a chuck moving operation of placing the substrate on a lower electrode and moving the lower electrode to a pre-set height;
a gap measuring operation of measuring a gap between a top surface of the substrate and a dielectric plate positioned above the lower electrode;
a correction determining operation of comparing the gap measured in the gap measuring operation with a pre-memorized process recipe to determine whether a correcting operation to correct the gap is necessary; and
a correcting operation of moving the lower electrode so that the gap is consistent with the process recipe when it is determined that the correcting operation is necessary,
wherein the correcting operation is performed during a second time period of processing the substrate by using plasma.

12. The control method of claim 11, wherein the correcting operation is performed even during a first time period during which the plasma is not generated.

13. The control method of claim 12, wherein a second velocity at which the lower electrode is moved in the second time period is slower than a first velocity at which the lower electrode is moved in the first time period.

14. The control method of any one of claims 11 to 13, further comprising:
a critical drive determining operation of determining whether a drive range of a driver that moves the lower electrode belongs to a critical drive range when the correcting operation is completed, the critical drive determining operation being performed between the correction determining operation and the correcting operation.

15. The control method of claim 14, wherein when the drive range of the driver belongs to the critical drive range in the critical drive determining operation, the correcting operation is performed, and when the drive range of the driver does not belong to the critical drive range in the critical drive determining operation, an alarm generating operation is performed to generate an alarm so that a user recognizes the fact that the drive range of the driver does not belong to the critical drive range.

16. An apparatus for processing a substrate by using plasma, the apparatus comprising:
a chamber having a processing space;
a lower electrode unit provided in a lower portion of the processing space;
an upper electrode unit provided in an upper portion of the processing space;
a gas supply unit for supplying gas to the processing space;
a gap measurement unit for measuring a gap between a substrate placed on the lower electrode unit and the upper electrode unit; and
a controller for generating a control signal for correcting the gap between the substrate placed on the lower electrode unit and the upper electrode unit, based on a measurement value measured by the gap measurement unit,
wherein the lower electrode unit includes:
a lower electrode on which the substrate is placed;
a driver for moving the lower electrode in upper and lower directions; and
a lower edge electrode configured in a shape of a ring surrounding the lower electrode when viewed from above, and
the upper electrode unit includes:
a dielectric plate positioned to face the lower electrode; and
an upper edge electrode configured in a ring shape surrounding the dielectric plate and facing the lower edge electrode, when viewed from above, and
the controller generates the control signal for correcting the gap between a top surface of the substrate placed on the lower electrode and the dielectric plate at a second time period during which the plasma is generated in the processing space.

17. The apparatus of claim 16, wherein the controller generates the control signal for correcting the gap between the top surface of the substrate placed on the lower electrode and the dielectric plate, even in a first time period during which the plasma is not generated.

18. The apparatus of claim 17, wherein the controller controls the driver such that a second velocity at which the driver moves the lower electrode in the second time period is slower than a first velocity at which the driver moves the lower electrode in the first time period.

19. The apparatus of claim 16 or 17, wherein the controller compares the gap between the dielectric plate and the top surface of the substrate placed on the lower electrode, measured by the gap measurement unit, with a pre-memorized process recipe to determine whether a correcting operation of correcting the gap is necessary, and
when the correcting operation is completed, the controller determines whether a drive range of the driver belongs to a critical drive range.

20. The apparatus of claim 19, wherein the gap measurement unit monitors the gap between the top surface of the substrate placed on the lower electrode and the dielectric plate while the correcting operation is performed, and
when the gap between the top surface of the substrate placed on the lower electrode and the dielectric plate is outside a preset upper limit gap or a preset lower limit gap, the controller generates a control signal for generating an alarm so that a user recognizes the fact that the gap between the top surface of the substrate placed on the lower electrode and the dielectric plate is outside the preset upper limit gap or the preset lower limit gap.

21. An apparatus for processing a substrate, the apparatus comprising:
a chamber having a processing space;
a lower electrode unit provided in a lower portion of the processing space;
an upper electrode unit provided in an upper portion of the processing space;
a gas supply unit for supplying gas to the processing space;
a power source for generating plasma from gas supplied by the gas supply unit;
a controller for generating a control signal for correcting a gap between a substrate placed on the lower electrode unit and the upper electrode unit, based on a measurement value measured by the gap measurement unit,
wherein the controller generates the control signal for correcting a gap between a top surface of the substrate placed on the lower electrode and the upper electrode unit in a first time period during which the plasma is not generated or in a second time period during which the plasma is generated in the processing space.

22. The apparatus of claim 21, wherein the controller controls the driver such that a second velocity at which the driver moves the lower electrode in the second time period is slower than a first velocity at which the driver moves the lower electrode in the first time period.

23. The apparatus of claim 22, wherein the controller compares whether the gap between the upper electrode unit and the top surface of the substrate placed on the lower electrode, measured by the gap measurement unit, with a pre-memorized process recipe to determine whether a correcting operation of correcting the gap is necessary, and
when the correcting operation is completed, the controller determines whether a drive range of the driver belongs to a critical drive range.

24. The apparatus of claim 23, wherein the gap measurement unit monitors the gap between the top surface of the substrate placed on the lower electrode and the upper electrode unit while the correcting operation is performed, and
when the gap between the top surface of the substrate placed on the lower electrode and the upper electrode unit is outside a preset upper limit gap or a preset lower limit gap, the controller generates a control signal for generating an alarm so that a user recognizes the fact that the gap between the top surface of the substrate placed on the lower electrode and the upper electrode unit is outside the preset upper limit gap or the preset lower limit gap.

25. The apparatus of any one of claims 21 to 24, wherein the upper electrode unit includes an upper electrode that is opposed to the lower electrode and generates plasma in a Capacitively Coupled Plasma (CCP) manner in the processing space.
